(19) Europäisches Patentamt

European Patent Office

Office européen des brevets

(11) EP 1 727 203 A1

(12) **EUROPEAN PATENT APPLICATION**

(43) Date of publication:
29.11.2006 Bulletin 2006/48

(51) Int Cl.:
*H01L 27/02* (2006.01)    *H03K 17/0814* (2006.01)
*F02P 3/04* (2006.01)

(21) Application number: 05425365.3

(22) Date of filing: 24.05.2005

(84) Designated Contracting States:
AT BE BG CH CY CZ DE DK EE ES FI FR GB GR
HU IE IS IT LI LT LU MC NL PL PT RO SE SI SK TR
Designated Extension States:
AL BA HR LV MK YU

(71) Applicant: STMicroelectronics S.r.l.
20041 Agrate Brianza (Milano) (IT)

(72) Inventors:
• **Torres, Antonino**
**95125 Catania (IT)**

• **Sueri, Stefano**
**95100 Catania (IT)**
• **Patti, Davide**
**95122 Catania (IT)**

(74) Representative: **Ferrari, Barbara et al**
**Botti & Ferrari S.r.l.,**
**Via Locatelli, 5**
**20124 Milano (IT)**

(54) **Monolithically integrated power IGBT device (Insulated Gate Bipolar Transistor)**

(57)     A power IGBT device is described being monolithically integrated and comprising an input terminal (I10) suitable to receive an input voltage (Vin) and an output terminal (O10) suitable to supply a current (Iout) with limited and predetermined highest value. Such IGBT device comprising an IGBT power element (2) inserted between said output terminal (O10) and a supply reference (GND) and having a control terminal (15) connected to the input terminal (I10) by means of a control circuit (12) comprising at least a transistor (18) inserted between the control terminal (15) and the supply reference (GND) and a resistive element (Rc) inserted between the input terminal (I10) and the control terminal (15).

Fig.5

EP 1 727 203 A1

**Description**

Field of application

The present invention relates to a monolithically integrated power IGBT (Insulated Gate Bipolar Transistor) device.

More specifically, the invention relates to a power IGBT device of the type comprising an input terminal suitable to receive an input voltage and an output terminal suitable to supply a current with limited highest value, an IGBT power element inserted between the output terminal and a GND supply reference and a control terminal connected to said input terminal by means of a control circuit.

Prior art

As it is well known to the skilled in the art, IGBT devices integrated for example by means of Power Mesh SMART-IGBT technology are realised monolithically by means of integration, in a single silicon substrate of a power element, such as an IGBT, and of a control circuit.

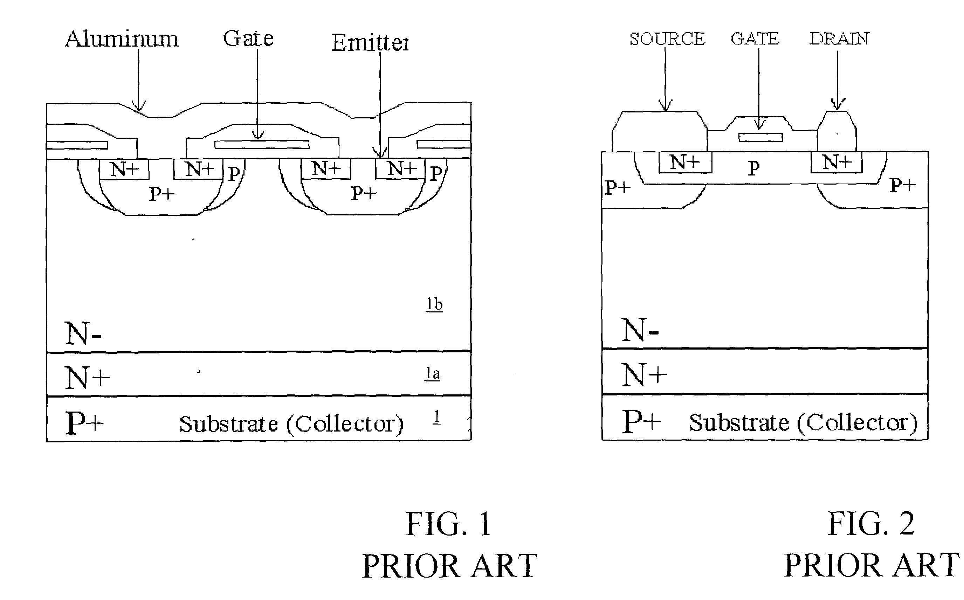

Such an IGBT power element is shown for example in figure 1 where, in a substrate 1, which, in the example, is of the P+ type, a first layer 1a of the N+ type and a second layer 1b of the N- type have grown epitaxially. In the second layer 1b doped wells of the P+ type are realised to form a body region of the IGBT power element. In the body region of the IGBT power element N+ doped regions are formed to define, in a standard way by means of suitable metalizations, gate or control and emitter terminals of such IGBT power element.

Below the substrate 1, a collector or output terminal of the IGBT power element is also defined.

In power IGBT devices realised with Power Mesh technology for applications wherein it is necessary to limit the highest current in the output terminal, the control circuit associated with the IGBT power element comprises elementary components, properly formed during a standard process suitable to realise the IGBT power element itself. Such process, maintained unaltered, allows power IGBT devices to obtain advantages also as regards their functionality since the different elementary components of the device are realised with uniformed technical characteristics.

In particular, the elementary components of the control circuit of a power IGBT device for applications wherein it is necessary to limit the output highest current essentially are: enhancement N-MOS transistors, polysilicon resistors, polysilicon diodes and high voltage JFET transistors.

As it is well known, an enhancement N-MOS transistor is realised by using a lateral diffusion of two P+ doped wells realised on the silicon substrate and suitable to form the body of the IGBT power element. By means of a standard process the gate, source and drain terminals are thus defined.

Moreover, to realise transistors with longer channel lengths, always by means of such technology, it is sufficient to ensure the channel continuity by providing the implantation of a suitable P doped silicon well between two P+ doped wells, as shown in figure 2.

In such case, the gate terminal of a transistor with higher channel is realised by adding a polysilicon stripe which is suitably separated from the body by means of an oxide, whereas, the source and drain terminals are obtained by means of a N+ well diffusion according to the standard process.

Elementary components such as resistances and polysilicon diodes are realised according to the process used to produce IGBT power elements for applications at high voltage, wherein it is necessary to limit the highest collector voltage, by using, for example, a chain of polysilicon back to back diodes connected between collector and gate of the IGBT power element.

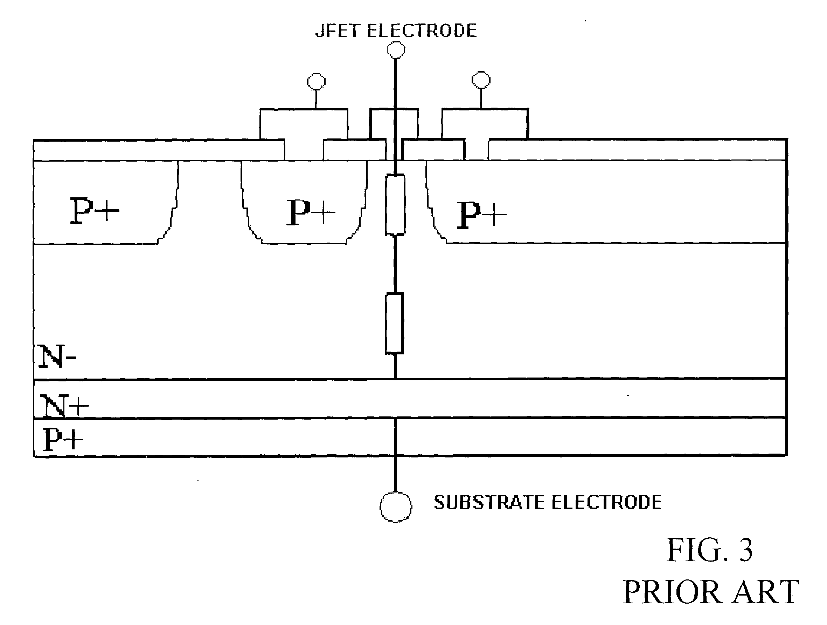

To obtain the high voltage JFET elementary component, as shown in figure 3, a throttling effect is instead exploited which is present in an area of the N- epitaxial region, closed between two P+ doped wells.

It is to be noted that such elementary components allow to realise simple control circuits for IGBT power elements suitable to obtain IGBT power devices with a limitation in the output highest current.

A possible application of such IGBT power devices is in the systems for electronic ignition where, in fact, driving a coil, present in the system, is required with a limitation of the output current.

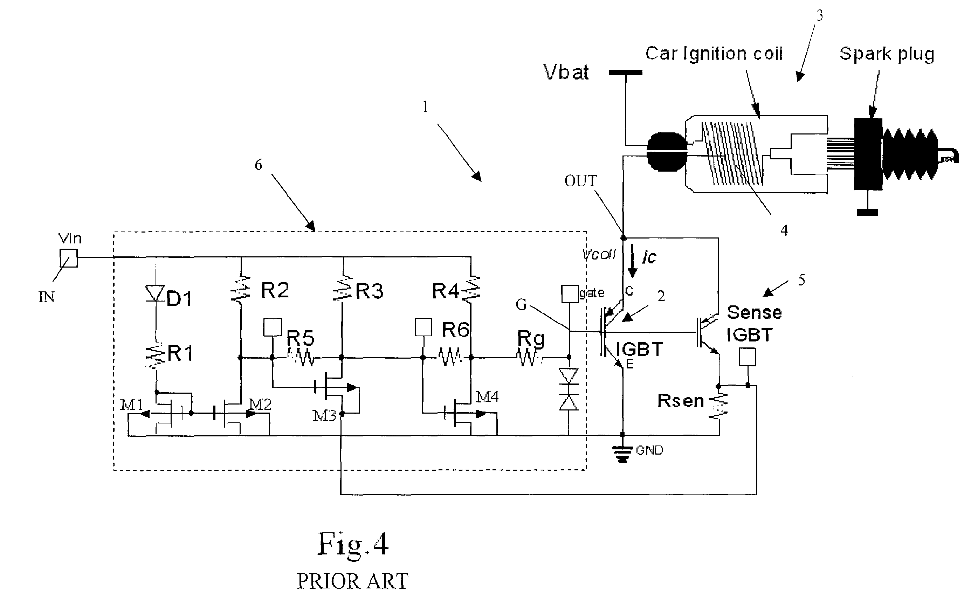

An embodiment of a coil driving system with limited output current power IGBT devices, of the known type, is shown in figure 4.

In such solution a power IGBT device 1 is highlighted with an input terminal IN connected to an input voltage Vin and an output terminal OUT which supplies a coil 4 of a schematically indicated ignition system 3. The power IGBT device 1 comprises a power IGBT element 2 inserted between the output terminal OUT and a ground reference GND and having a gate terminal G connected to the input voltage Vin by means of the interposition of a control circuit 6. The control circuit 6, inserted between the input voltage Vin and the ground reference GND, comprises a plurality of components, such as MOS transistors and resistors, suitably connected in a known way.

The control circuit 6 feedback receives the current being present on the output terminal OUT through a power Sense-IGBT element 5, placed in parallel to the power IGBT element 2, and it drives the power element 2 limiting its highest output current value.

In particular, the operation of the control circuit 6 provides that an N-MOS transistor, called M3, senses the voltage across a resistance Rsen of the Sense-IGBT element 5, voltage which is proportional to the output current of the power IGBT element 2. The transistor M3 drives an N-MOS transistor, called M4. If the voltage sensed by the transistor M3 increases, the transistor M3 passes from the ohmic region of operation to the saturation and similarly the transistor M4 suitably biases, by means of a resistance Rg, the input of the power IGBT element 2, so that the output current does not exceed a predetermined value.

The main drawback power IGBT devices of this type exhibit is that of particular voltage oscillations in tension which appear in the output terminal OUT when a current limitation occurs at the output terminal itself. Such oscillations reflect on the secondary winding of the coil 4 causing undesired sparks on the plug connected thereto.

It is suggested, to stabilise the voltage on the output terminal OUT, realising a control circuit which comprises compensation networks able to introduce a dominant pole, in the transfer function, capable of compensating possible oscillations.

However, in power IGBT devices obtained by means of Power Mesh technology such solution cannot be realised. In fact, in such case, the elementary components which can be realised in the control circuit cannot be compared to the resistances due to the incompatibility existing between the threshold voltage of an N-MOS transistor, typically equal to 2V, and that of the supply voltage Vin, typically equal to 3V. The control circuit does not comprise instead active loads, i.e. components such as for example those of the capacitors which could introduce the dominant pole required in the transfer function.

The approach indicated is made even more difficult due to the absence, in the Power Mesh technology, of processes for the realisation of elementary components such as capacitors.

A further drawback the power IGBT device according to the prior art and shown in figure 4 exhibits is the poor shielding with respect to the presence of external electromagnetic fields, which causes disturbs invalidating the operation of the device itself.

The technical problem underlying the present invention is that of devising a monolithically integrated power IGBT device having such structural and functional characteristics as to allow to overcome the limits and drawbacks still affecting the devices realised according to the prior art.

Summary of the invention

The solution idea underlying the present invention is that of realising a control circuit of a power element of an IGBT device comprising a control circuit configured in such a way as to clamp the input voltage of the power element so as to limit the highest output current of the IGBT device.

On the basis of such solution idea the technical problem is solved by a device as previously indicated and defined by the characterising part of claim 1.

The characteristics and advantages of the device according to the invention will be apparent from the following description of an embodiment thereof given by way of indicative and non limiting example with reference to the annexed drawings.

Brief description of the drawings

In such drawings:

figures 1, 2 and 3 show a section view of a substrate portion comprising respectively a power IGBT device, an increased channel transistor and a JFET transistor realised according to the prior art;

figure 4 shows a circuit scheme of a power IGBT device with a control circuit realised according to the prior art;

figure 5 shows a circuit scheme of an IGBT device realised according to the present invention;

figure 6 shows a further embodiment of the IGBT device realised according to figure 5.

Detailed description

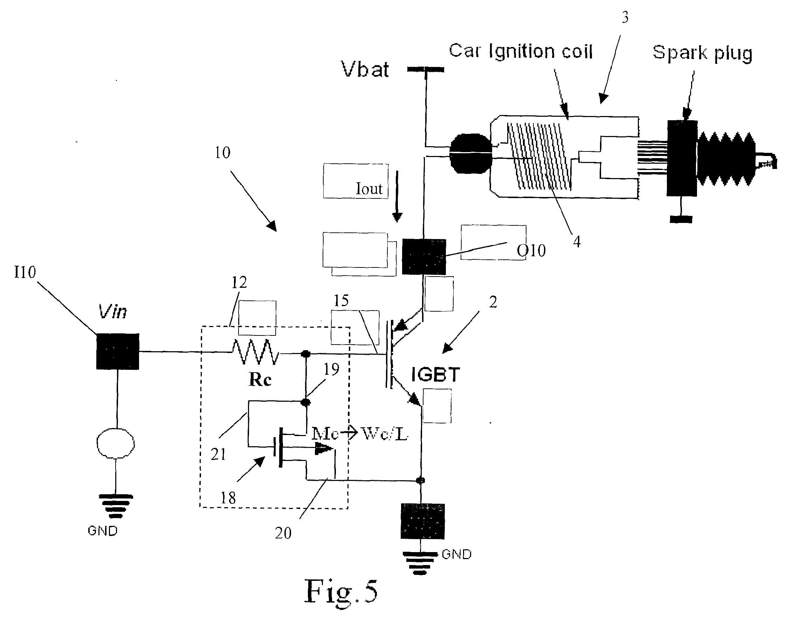

With reference to the annexed figures and in particular to figure 5, 10 indicates a power IGBT device realised according to the present invention suitable to supply, on an output terminal O10, an input of a coil 4 of an ignition device 3, which is shown in a schematic way, with a current Iout having limited highest value.

The power IGBT device 10 exhibits an input terminal I10 suitable to receive a proper input voltage Vin.

The power IGBT device 10 also comprises a power element 2 inserted between the output terminal O10 and a ground voltage reference GND.

The power element 2 comprises a control terminal 15, in particular a gate terminal connected to the input terminal I10 by means of interposition of a control circuit 12.

Advantageously, according to the present invention, the control circuit 12 comprises a transistor 18, of the MOS type, connected with a first conduction terminal 19 to the control terminal 15 of the power element 2 and with a second conduction terminal 20 to the ground voltage reference GND.

The transistor 18 is suitably diode-connected, i.e. it exhibits a third command terminal 21 connected to the first conduction terminal 19 and thus to the control terminal 15 of the power element 2.

Moreover, advantageously, the control circuit 12 exhibits a resistive element Rc inserted between the input terminal I10 and the control terminal 15 of the element 10. Such resistive element Rc can advantageously be a polysilicon resistance as indicated in figure 5 or a MOS transistor.

Suitably, the resistance Rc, in presence of a defined input voltage Vin, allows to bias the transistor 18.

In the present embodiment the transistor 18 is of the enhancement N-MOS type.

As regards the operation, the transistor 18, diode-connected and biased by the resistance Rc, allows to adjust the input voltage of the power element 2, in correspondence with the control terminal 15, allowing to limit, consequently, the highest value of the output current Iout from the output terminal O10, which supplies the coil 4 of the ignition device 3.

Advantageously thus the proposed solution allows to limit the output current Iout of the power element 2 by clamping the voltage at the control terminal 15 by means of a simple control circuit 12 comprising a transistor 18 being diode-connected and biased by a resistance Rc.

The power element 2 and the transistor 18 are monolithically integrated, during the same process, i.e. by means of Power Mesh "Smart-Igbt" technique, thus, there exists a certain correlation between their physical characteristics. In particular, it comes that the MOS transistor 18 exhibits a threshold voltage which is correlated with the threshold voltage of the power element 2 since both exhibit, obviously, a same polysilicon structure of the control terminals 15 and of the command terminal 21.

In particular, moreover, according to the dimensions of the power element 2, it is possible to change the value of the voltage at the control terminal 15, the highest current value Iout thus being adjustable at the output terminal O10.

The present solution can be subjected to several versions all within the same scope of protection.

In particular, it is possible to realise, as further embodiment, a monolithically integrated power IGBT device 10 with the value of the highest output current Iout being adjustable.

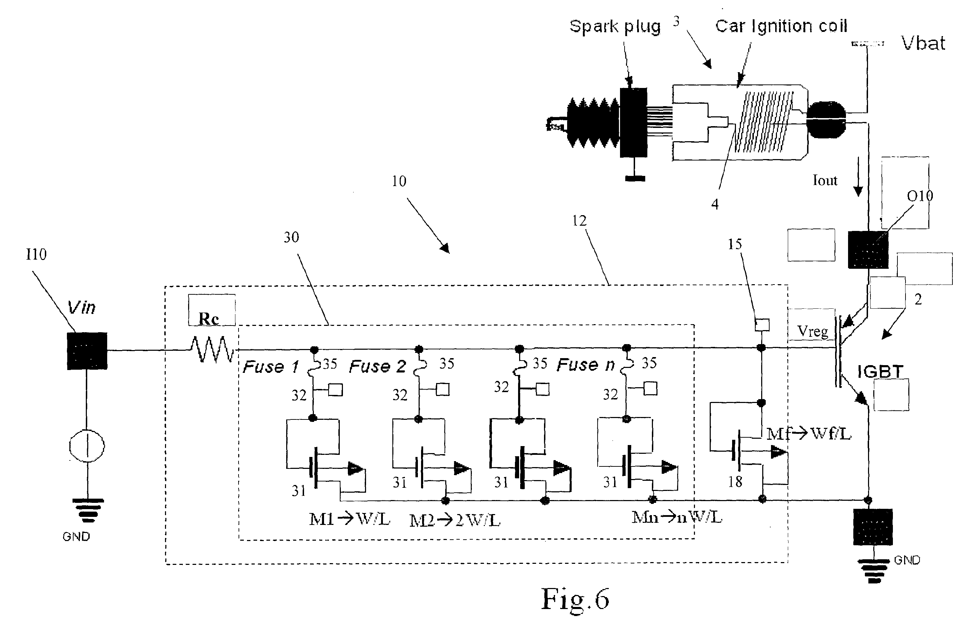

A preferred embodiment of this version is shown in figure 6, and, in the following description, the same numbers previously used to indicate structurally and functionally similar components will be maintained.

The power IGBT device 10 is connected by means of an output terminal O10 to a coil 4 of an ignition device 5 and by means of an input terminal I10 to a suitable input voltage Vin.

The device 10 comprises a power element 2 inserted between the output terminal O10 and a ground voltage reference GND and it exhibits a control terminal 15 connected to the input terminal I10 by means of the interposition of a control circuit 12.

Advantageously, according to the present invention, the control circuit 12 comprises a transistor 18, of the MOS type, connected between the control terminal 15 of the power element 10 and the ground voltage reference GND.

The transistor 18 is suitably diode-connected and it is suitably biased, to the input voltage Vin, by means of a resistance Rc connected between the input terminal I10 and the control terminal 15 of the power element 2.

Advantageously, moreover, according to the present embodiment, the control circuit 12 comprises a modular element 30 which allows to adjust a voltage Vreg to the control terminal 15 of the power element 10.

Suitably, the modular element 30 is inserted between said control terminal 15 and said ground reference GND and it comprises a plurality n of transistors 31, conveniently diode-connected, arranged in parallel to each other and in parallel to the transistor 18.

Advantageously, each of the n transistors 31 comprises an output terminal 32 connected to the control terminal 15 by means of an enable fuse 35. The fuses 35, suitably programmed, allow to enable or disable the corresponding transistors 31.

Conveniently, moreover, the n transistors 31 of the modular element 30 exhibit a structure with a channel length L being identical to each other but with a multiple width W, advantageously according to a binary weight, obtaining, considering the transistor 18 and the n transistors 31, a global width Wc equal to:

$$Wc = W_f + W + 2W + \ldots + nW$$

Where $W_f$ indicates the channel width of the transistor 18, while W, 2W,...nW respectively indicate the channel widths of the n transistors 31 defining the modular element 30.

When all the fuses enable the n transistors 31 the global channel width is $W_c$, whereas such value is reduced when the fuses suitably disable some of the n transistors 31. In the case wherein the whole modular element 30 is disabled the global channel $W_c$ is equal to $W_f$ i.e. simply the channel width of the transistor 18.

Thus, by indicating as $V_f$ the voltage across the transistor 18 of dimensions Wf/L and as $V_c$ the voltage across a transistor equivalent to the transistor 18 in parallel to the modular element 30 of dimensions Wc/L it is possible to modulate the voltage Vreg applied to the control terminal 15 of the transistor 18 with a step equal to $(2^n-1)$ where n is the number of the transistors 31.

In other words, the proposed solution allows to vary the voltage Vreg at the control terminal 15 in values comprised between $V_c$ and $V_f$ according to how many of the n transistors 31 of the modular element 30 are enabled, in a scale of $(2^n-1)$ possible values.

Main advantage of the power IGBT device realised according to the present invention is that of exhibiting a control circuit which comprises a reduced number of elementary components and which allows to limit the output current by clamping the voltage onto the control terminal of the power element, stabilising in the meantime the current at the output terminal.

Another advantage is the improved dynamic behaviour of the power IGBT device realised according to the present invention linked to the fact that the control circuit, not exhibiting amplifier stages, allows to limit the output current avoiding oscillations on the collector voltage.

A further advantage of the present invention is that of being able to adjust, in a proportional way, according to the number of the transistors defining the modular element, the voltage at the control terminal of the power element and thus define similar modular values of the highest current present at the output terminal. This obviously allows to remarkably amplify the field of use of a single power IGBT device thus realised.

Another advantage of the present invention is the high immunity the device exhibits linked to the fact that the control circuit realised with the elementary components, such as resistors and transistors, is more shielded against the disturbs coming from external electromagnetic fields, not needing, moreover, any compensation network.

Moreover, the present invention realises a monolithically integrated power IGBT device which allows to correlate the electrical characteristics of all the components optimising the performances during the dynamic operation and allowing, in the meantime, an improved adaptation to the application.

**Claims**

1. Monolithically integrated power IGBT device comprising an input terminal (I10) suitable to receive an input voltage (Vin) and an output terminal (O10) suitable to supply a current (Iout), an IGBT power element (2) inserted between said output terminal (O10) and a supply reference (GND) and having a control terminal (15) connected to said input terminal (I10) by means of a control circuit (12) **characterised in that** said control circuit (12) comprises at least a transistor (18) inserted between said control terminal (15) and said supply reference (GND) and a resistive element (Rc) inserted between said input terminal (I10) and said control terminal (15).

2. IGBT device according to claim 1 **characterised in that** said at least one transistor (18) is diode-configured.

3. IGBT device according to claim 1 **characterised in that** said at least one transistor (18) preferably is a transistor of the enhancement N-MOS type.

4. IGBT device according to claim 1 **characterised in that** said resistive element (Rc) is chosen between a polysilicon resistance or a MOS transistor.

5. IGBT device according to claim 3 **characterised in that** said transistor (18) is biased by means of said resistive element comprising a resistance (Rc).

6. IGBT device according to claim 1 **characterised in that** said control circuit (12) further comprises a modular element (30) inserted between said control terminal (15) and said supply reference (GND).

7. IGBT device according to claim 6 **characterised in that** said modular element (30) comprises a plurality of transistors (31) being diode-connected and arranged in parallel to one another and in parallel to said transistor (18).

8. IGBT device according to claim 7 **characterised in that** each of said transistors (31) comprises an output terminal (32) connected to said control terminal (15) by means of an enable fuse (35).

9.  IGBT device according to claim 8 **characterised in that** said transistors (31) of said modular element (30) exhibit a structure with a channel length (L) being identical to each other and a multiple width (W) according to a binary weight.

10. IGBT device according to claim 9 **characterised in that** said transistor (18) and said transistors (31) exhibit channels comprising an identical length (L) and a global width (Wc) equal to:

$$Wc = W_f + W + 2W + ... + nW$$

where:

$W_f$ is a width of the channel of said transistor (18);
W, 2W,...nW are the widths of the channels of said transistors (31) and
n is the number of said transistors (31).

11. Device according to claim 10 **characterised in that** a Vreg voltage modulated with a step equal to $(2^n-1)$, where n is the number of said transistors (31), is applied to the said control terminal (15).

FIG. 2
PRIOR ART

FIG. 1
PRIOR ART

7

JFET ELECTRODE

P+    P+    P+

N-

N+

P+

SUBSTRATE ELECTRODE

FIG. 3
PRIOR ART

Fig.4
PRIOR ART

Fig.5

EP 1 727 203 A1

Fig.6

**European Patent Office**

**EUROPEAN SEARCH REPORT**

Application Number

EP 05 42 5365

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ALOISI P A ET AL: "A new IGBT with a monolithic self-protection circuits" EPE'97. 7TH EUROPEAN CONFERENCE ON POWER ELECTRONICS AND APPLICATIONS EPE ASSOC BRUSSELS, BELGIUM, vol. 1, 1997, pages 293-295 vol.1, XP009061135 ISBN: 90-75815-02-6 * figures 1,2,5,6 * | 1,3-5 | INV. H01L27/02 H03K17/0814 F02P3/04 |
| X | JUNYANG LUO ET AL: "Design of LIGBT protection circuit for smart power integration" IEEE TRANSACTIONS ON INDUSTRIAL ELECTRONICS IEEE USA, vol. 47, no. 4, August 2000 (2000-08), pages 744-750, XP002366743 ISSN: 0278-0046 * figures 3,9 * | 1,3-5 | |
| X | EP 1 284 362 A (HITACHI, LTD; HITACHI CAR ENGINEERING CO., LTD) 19 February 2003 (2003-02-19) * abstract; figure 3 * | 1,2 | TECHNICAL FIELDS SEARCHED (IPC) H01L H03K F02P |
| A | MUSUMECI S ET AL: "A new gate circuit performing fault protections of IGBTs during short circuit transients" CONFERENCE RECORD OF THE 2002 IEEE INDUSTRY APPLICATIONS CONFERENCE. 37TH IAS ANNUAL MEETING (CAT. NO.02CH37344) IEEE PISCATAWAY, NJ, USA, vol. 4, 2002, pages 2614-2621 vol., XP002366744 ISBN: 0-7803-7420-7 * figure 1e * | 1 | |

-/--

The present search report has been drawn up for all claims

| Place of search | Date of completion of the search | Examiner |
|---|---|---|
| Munich | 21 September 2006 | Götz, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# EP 1 727 203 A1

**European Patent Office**

## EUROPEAN SEARCH REPORT

Application Number

EP 05 42 5365

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 3 403 270 A (PACE ROBERT E ET AL) 24 September 1968 (1968-09-24) * figure 1 * | 2 | |
| A | US 2003/117758 A1 (YOSHIDA MITSURU) 26 June 2003 (2003-06-26) * figure 1 * | 1 | |
| A | TORRES A ET AL: "A fully protected monolithic smart IGBT developed with a standard technology" PCIM'99. EUROPE. OFFICIAL PROCEEDINGS OF THE THIRTY-NINTH INTERNATIONAL POWER CONVERSION CONFERENCE ZM COMMUN. GMBH NURNBERG, GERMANY, 1999, pages 79-83, XP009061155 ISBN: 3-928643-22-3 * the whole document * | 1-5 | |
| A | EP 1 357 461 A (DAIMLERCHRYSLER CORPORATION) 29 October 2003 (2003-10-29) * column 2, lines 43,44, paragraph 4 * | 6 | TECHNICAL FIELDS SEARCHED (IPC) |
| A | US 4 020 397 A (FASULKEY ET AL) 26 April 1977 (1977-04-26) * figure 1 * | 8 | |

The present search report has been drawn up for all claims

| Place of search | Date of completion of the search | Examiner |
|---|---|---|
| Munich | 21 September 2006 | Götz, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent

Office

Application Number

EP 05 42 5365

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

| | | |
|---|---|---|
| **European Patent Office** | **LACK OF UNITY OF INVENTION**<br>**SHEET B** | Application Number<br>EP 05 42 5365 |

The Search Division considers that the present European patent application does not comply with the requirements of unity of invention and relates to several inventions or groups of inventions, namely:

    1. claims: 1-5

        Monolithic IGBT with transistor and resistive element

    1.1. claim: 2

            Diode-configured transistor

    1.2. claim: 3

            Enhancement N-MOS transistor

    1.3. claim: 4

            Polysilicon resistance or MOS transistor
              ---

    2. claims: 6-11

            Modular element
              ---

Please note that all inventions mentioned under item 1, although not necessarily linked by a common inventive concept, could be searched without effort justifying an additional fee.

## ANNEX TO THE EUROPEAN SEARCH REPORT
## ON EUROPEAN PATENT APPLICATION NO.

EP 05 42 5365

This annex lists the patent family members relating to the patent documents cited in the above-mentioned European search report.
The members are as contained in the European Patent Office EDP file on
The European Patent Office is in no way liable for these particulars which are merely given for the purpose of information.

21-09-2006

| Patent document cited in search report | | Publication date | Patent family member(s) | | Publication date |
|---|---|---|---|---|---|
| EP 1284362 | A | 19-02-2003 | CN | 1423729 A | 11-06-2003 |
| | | | DE | 60021618 D1 | 01-09-2005 |
| | | | WO | 0190572 A1 | 29-11-2001 |
| | | | US | 6595194 B1 | 22-07-2003 |
| US 3403270 | A | 24-09-1968 | NONE | | |
| US 2003117758 | A1 | 26-06-2003 | DE | 10260279 A1 | 24-07-2003 |
| | | | JP | 2003197913 A | 11-07-2003 |
| EP 1357461 | A | 29-10-2003 | US | 2003197993 A1 | 23-10-2003 |
| US 4020397 | A | 26-04-1977 | BE | 833749 A1 | 24-03-1976 |
| | | | CA | 1033004 A1 | 13-06-1978 |
| | | | DE | 2541817 A1 | 15-04-1976 |
| | | | FR | 2286555 A1 | 23-04-1976 |
| | | | GB | 1476611 A | 16-06-1977 |
| | | | JP | 1008202 C | 31-07-1980 |
| | | | JP | 51060141 A | 25-05-1976 |
| | | | JP | 54044586 B | 26-12-1979 |
| | | | NL | 7510324 A | 29-03-1976 |

EPO FORM P0459

For more details about this annex : see Official Journal of the European Patent Office, No. 12/82